# EUROPÄISCHE PATENTSCHRIFT

(11) **EP 0 349 068 B1**
(45) Veröffentlichungstag und Bekanntmachung des Hinweises auf die Patenterteilung: **28.12.1994**
(21) Anmeldenummer: 89201656.9
(22) Anmeldetag: 23.06.1989
(51) Int. Cl.: H01L 21/00

(54) **Verfahren zur Prozessführung bei der physikalisch/chemischen Behandlung von Halbleitern in einem Ofen**
Method for guiding a process during the physical/chemical treatment of semiconductors in an oven
Méthode de contrôle du procédé lors du traitement physique/chimique de semi-conducteurs dans un four

(30) Priorität: 29.06.1988 DE 3821907
(43) Veröffentlichungstag der Anmeldung: 03.01.1990
(73) Patentinhaber: Philips Patentverwaltung GmbH, 22335 Hamburg (DE); Philips Electronics N.V., 5621 BA Eindhoven (NL)
(72) Erfinder: Kürzinger, Werner, Dr., D-2000 Hamburg 54 (DE)
(74) Vertreter: Hartmann, Heinrich, Dipl.-Ing.

(56) Entgegenhaltungen:
- US-A- 3 980 042
- JOURNAL OF APPLIED PHYSICS. vol. 61, no. 4, 15 Februar 1987, NEW YORK US Seiten 1620 - 1627; B. Van Schravendijk et al: ".Modeling and control of the wafer temperatures in a diffusion furnace"
- IEEE TRANSACTIONS ON AUTOMATIC CONTROL. vol. AC-28, no. 3, März 1983, NEW YORK US Seiten 388 - 400; V. Lumelsky: "Estimation and prediction of unmeasurable variables in the steel mill soaking pit control system"
- SOLID STATE TECHNOLOGY. vol. 20, no. 7, Juli 1977, WASHINGTON US Seiten 34 -37; D. Landis et al.: "Automatic diffusion furnace system using microprocessor control"
- JOURNAL A. vol. 28, no. 4, November 1987, ANTWERPEN BE Seiten 177 - 187; J. van Amerongen et al.: "Modelling and control of a diffusion furnace"

## Beschreibung

Die Erfindung bezieht sich auf eine Anordnung zur Prozeßführung bei der physikalisch/chemischen Behandlung von Halbleitern in einem Ofen mit einem Prozeßrechner, der zur Erzeugung einer Schicht mit bestimmter Zielgröße von bestimmten chemischen und/oder physikalischen Eigenschaften die Parameter der dem Ofen zuführbaren Größen regelt, wobei der Prozeßrechner einen Vergleich vorgegebener Parameterwerte mit den gemessenen Parameterwerten durchführt. Nachfolgend wird der Soll-Wert einer Zielgröße Kurz "Soll-Zielgröße", der Ist-Wert kurz "Ist-Zielgröße" genannt.

Solche Prozesse zur Behandlung von Halbleitern in einem Ofen sind z.B. Diffusion, Oxidation, Epitaxie, Chemical Vapour Deposition (Abscheidung) u.a. Hierbei wird eine Schicht mit bestimmten Eingenschaften gebildet. Beispielsweise kann mit einem Oxidationsprozeß eine Isolierschicht oder durch einen epitaktischen Prozeß eine Halbleiterschicht mit einem bestimmten Widerstand erzeugt werden. Die Soll-Zielgröße eines solchen Prozesses ist z.B. eine bestimmte Dicke einer Schicht. Die Soll-Zielgröße wird durch Regelung der Parameter der dem Ofen zugeführten Größen erzeugt. Dem Ofen werden z.B. Gase zugeführt, deren Durchfluß vom Prozeßrechner geregelt wird, ebenso wie beispielsweise die Temperatur des Ofens. Anhand eines vorgegebenen Temperatur-Zeit-Durchfluß-Ablaufes (Steuerungsablauf) werden die vorgegebenen Parameterwerte vom Prozeßrechner eingestellt. Die Parameterwerte werden gemessen und mit den vorgegebenen Parametern verglichen und durch den Prozeßrechner auf den vorgegebenen Wert geregelt.

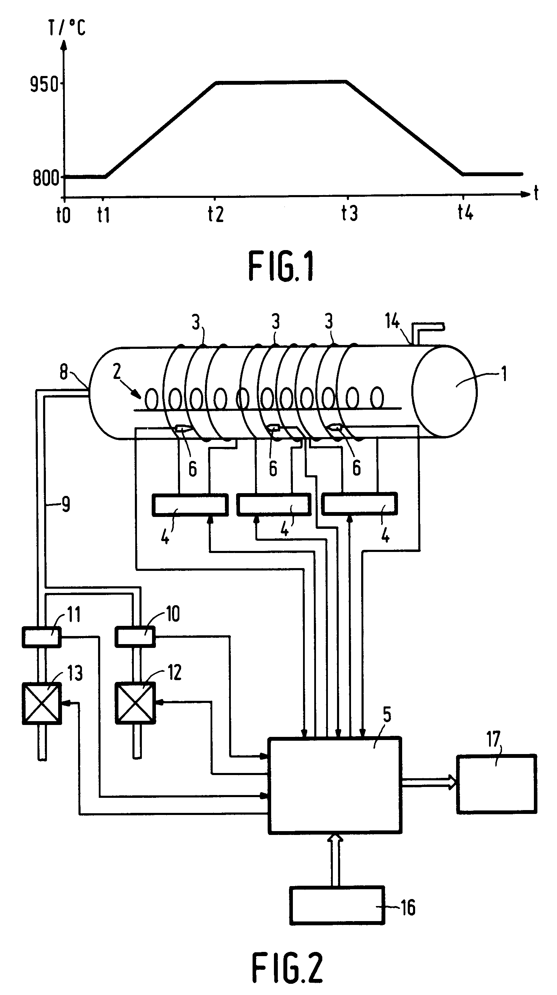

Ein typischer Steuerungsablauf für einen Oxidationsprozeß ist in Fig. 1 dargestellt. Bis zum Zeitpunkt to ist in den auf 800°C aufgeheizten und mit Halbleiterscheiben bestückten Ofen Stickstoffgas (N₂) geflossen. Zum Zeitpunkt to wird der Gaszufluß des Stickstoffgases von 1 l/min auf 5 l/min erhöht und ein Sauerstoffgas (O₂) zusätzlich mit 0,1 l/min zugeführt. Die Temperatur wird dann vom Zeitpunkt t1 ab kontinuierlich auf 950°C erhöht. Zum Zeitpunkt t2 hat der Ofen eine Temperatur von 950°C. Die Gaszufuhr des Sauerstoffgases wird dann auf 3 l/min erhöht und die des Stickstoffgases beendet. Angeschaltet wird der Zufluß des Sauerstoffgases zum Zeitpunkt t3; der Zufluß des Stickstoffgases wird auf 5 l/min eingestellt. Die Temperatur wird auf 800°C erniedrigt. Vom Zeitpunkt t3 ab beginnt die Abkühlphase, in der ein Anwachsen der Oxidationsschicht praktisch nicht mehr stattfindet. Zum Zeitpunkt t4 wird die Zufuhr des Stickstoffgases auf 1 l/min herabgesetzt. Die Halbleiterscheiben können dann dem Ofen entnommen werden.

Die eingangs erwähnte Anordnung ist aus der US-PS 39 80 042 bekannt. Hierbei werden in einem Quarzofen Halbleiterstäbe mit Silicium beschichtet, das aus einer gasförmigen Siliciumverbindung stammt. Dieses Silicium enthaltende Gas wird zusammen mit einem aus einer Trägergasquelle stammenden Trägergas dem Ofen zugeführt. Geregelt wird der Durchfluß der Gase von einem Prozeßrechner, die auch die Ofentemperatur regelt. Meßwertaufnehmer messen die Ofentemperatur und den Durchfluß der zum Ofen geführten Gase. Der Prozeßrechner ist mit einem Programmgenerator verbunden, der den Steuerungsablauf abgespeichert hat und dem Prozeßrechner zuführt.

Bei den oben genannten Halbleiterprozessen, die in einem Ofen durchgeführt werden, kann eine Messung der Zielgröße während des Prozesses nicht vorgenommen werden. In der bisherigen Praxis wird daher ein Steuerungsablauf vorgegeben, der durch empirische Untersuchungen oder Simulationsberechnungen ermittelt worden ist. Treten am Ofen beispielsweise Temperaturschwankungen auf, wird der Prozeßablauf gestört und die erforderliche Soll-Zielgröße (z.B. Schichtdicke bei Oxidation) wird nicht erreicht, da der Steuerungsablauf nicht wie vorgegeben ausgeführt worden ist. Störungen, die bei der physikalisch/chemischen Behandlung von Halbleitern auftreten, bewirken in der Regel, daß der behandelte Halbleiter nachgearbeitet werden oder aussortiert werden muß. Das bedeutet ein Verlust von Material und eine Verlängerung der Prozeßzeit.

Der Erfindung liegt daher die Aufgabe zugrunde, eine Anordnung zur Prozeßführung bei der physikalisch/chemischen Behandlung von Halbleitern in einem Ofen zu schaffen, die auch bei Störungen die Soll-Zielgröße annähernd erreicht.

Die Aufgabe wird bei einer Anordnung der eingangs genannten Art dadurch gelöst, daß der Prozeßrechner zu vorgewählten Zeitpunkten aus den gemessenen Parameterwerten mittels einer Modellrechnung den Ist-Wert der Zielgröße berechnet und die Behandlung beendet, wenn der Ist-Wert den Soll-Wert der Zielgröße erreicht.

Bei der erfindungsgemäßen Anordnung ermittelt der Prozeßrechner zu vorgewählten Zeitpunkten anhand einer Modellrechnung (Simulationsberechnung) die Ist-Zielgröße. In der Modellrechnung wird der Prozeßablauf nachgebildet, so daß dieselben Prozesse, die im Ofen ablaufen, durch die Modellrechnung simuliert werden. Eine solche Modellrechnung kann z.B. mit Hilfe des Programmes "SUPREM III" (A PROGRAM for Integrated Circuit Process Modelling and Simulation von C. P. Ho, S. E. Hansen und P. M. Fahey, TECHNICAL REPORT No. SEL 84-001, Stanford Electronics Laboratories, Stanford University, Stanford, California, July 1984) realisiert werden. Der Prozeßrechner vergleicht nach der Berechnung die Ist-Zielgröße mit der Soll-Zielgröße und beendet die Behandlung der Halbleiter, wenn die Ist-Zielgröße die Soll-Zielgröße erreicht hat. Tritt während eines Prozesses keine Störung auf, so wird ein normaler Steuerungsablauf durchgeführt, d.h. die Behandlung wird beendet, wie das im Steuerungsablauf bisher vorgesehen war, da die Ist-Zielgröße die Soll-Zielgröße erreicht hat. Falls eine Störung auftritt, wird die Behandlung verlängert oder verkürzt, bis die Ist-Zielgröße gleich der Soll-Zielgröße ist.

Der Prozeßablauf kann aber auch durch die Regelung eines Parameters in Abhängigkeit von der Abweichung der Ist-Zielgröße zur Soll-Zielgröße vorgenommen werden. Die Werte der anderen Parameter sind dann vorgegeben.

Durch die erfindungsgemäße Anordnung kann auch bei einer Prozeßstörung die Soll-Zielgröße erreicht werden. Es ist also keine Nachbearbeitung und keine Aussortierung von behandelten Halbleitern notwendig. Dadurch wird Material eingespart und eine Verlängerung der Prozeßzeit vermieden.

Es sei noch erwähnt, daß aus der DE-PS 31 33 222 eine selbsteinstellende Regelung eines technischen Prozesses nach dem Modellverfahren bekannt ist. Hierbei wird parallel zum Prozeß ein elektrisches Modell des Prozesses zur Ermittlung und Korrektur von Führungsgrößen (Sollwerte) der Regelung betrieben. Mit dieser Regelung wird eine Optimierung der Führungsgrößen erreicht. Die Zielgröße des technischen Prozesses ist im Gegensatz zur Zielgröße der erfindungsgemäßen Anordnung meßbar. Es wird in der DE-PS 31 33 222 also nicht das Problem behandelt, eine Ist-Zielgröße mit Hilfe einer Modellrechnung zu ermitteln.

In einer Weiterbildung der Erfindung ist vorgesehen, daß der Prozeßrechner die Behandlung abbricht, wenn ein Parameterwert einen vorgegebenen Bereich unter- bzw. überschreitet. Eine solche Unter- bzw. Überschreitung eines Parameterwertes kann z.B. bei einem Ausfall einer Heizung am Ofen auftreten. Der vorgegebene Bereich ist der Bereich in dem eine einwandfreie Behandlung der Halbleiter gewährleistet ist. Wenn der Parameterwert außerhalb dieses Bereiches liegt, erfolgt ein Abbruch. Es ist vorteilhaft, wenn der Prozeßablauf dokumentiert wird, in dem die gemessenen Parameterwerte abgespeichert werden. Im Falle eines Prozeßabbruches kann aufgrund der bis dahin gemessenen Parameterwerte eine Nachbehandlung der Halbleiter in einem Nachbearbeitungsprozeß auf einfache Art durchgeführt werden.

Die physikalisch/chemische Behandlung der Halbleiter besteht aus einer Schichtbildung. Beispielsweise kann eine als Isolierschicht ausgebildete Oxidationsschicht durch Oxidation oder eine Widerstandsschicht durch Epitaxie ausgebildet werden. Die Soll-Zielgröße ist in beiden Fällen die Dicke der Schicht. Hierbei wird unter Zuhilfenahme eines Trägergases und wenigstens eines weiteren Gases die Schichtbildung vorgenommen. Bei einem Oxidationsprozeß z.B. ist das Trägergas Stickstoff und das weitere Gas Sauerstoff. Der Prozeßrechner regelt den Durchfluß der Gase und die Temperatur des Ofens.

Ein Ausführungsbeispiel der Erfindung wird nachstehend anhand der Zeichnungen näher erläutert. Es zeigen:
Fig. 1 einen typischen bisher verwendeten Steuerungsablauf für einen Oxidationsprozeß und
Fig. 2 eine Anordnung zur Bildung einer Oxidationsschicht auf Halbleitern in einem Ofen.

In dem in Fig. 2 schematisch dargestellten Ofen 1 sind mehrere Halbleiterscheiben 2 senkrecht aufgereiht, die mit einer durch Oxidation erzeugten Isolierschicht beschichtet werden sollen. Die Aufheizung des Ofens erfolgt durch drei Heizungen 3, die hier schematisch als Heizspiralen dargestellt sind. Jeweils ein Stellglied 4 für die Heizungen 3 wird von einem Prozeßrechner 5 gesteuert. Die Temperatur der Heizungen 3 wird durch jeweils einen Meßfühler 6 gemessen; die Meßwerte werden dem Prozeßrechner 5 zugeführt. Durch Vergleich der vorgegebenen Temperaturwerte mit den gemessenen Temperaturwerten regelt der Prozeßrechner 5 die Heizungen auf die erforderliche Temperatur.

Der Ofen 1 weist noch eine Gaseinlaßöffnung 8 auf, die mit einer Gasleitung 9 verbunden ist. Die Gasleitung führt auf zwei Durchflußmesser 10 und 11. Über ein Ventil 12 und den Durchflußmesser 10 wird in die Gasleitung 9 ein Stickstoffgas (N₂) gegeben. Von einer weiteren Gasquelle wird über ein Ventil 13 und den Durchflußmesser 11 ein Sauerstoffgas (O₂) in die Gasleitung 9 geleitet. Gesteuert werden die Ventile 12 und 13 von dem Prozeßrechner 5, der anhand des gemessenen Durchflußes mittels der Durchflußmesser 10 und 11 die Einstellung der Ventile 12 und 13 regelt. Am Ofen 1 ist des weiteren noch eine Gasauslaßöffnung 14 vorgesehen.

Der Prozeßrechner 5 ist mit einer Eingabeanordnung 16 verbunden, über die alle für den Oxidationsprozeß erforderlichen Daten eingegeben werden. Des weiteren ist an den Prozeßrechner 5 eine Ausgabeanordnung 17 angeschlossen, über die die laufenden Prozeßdaten ausgegeben werden. Eine solche Ausgabeanordnung 17 kann z.B. ein Drucker oder ein Bildschirm sein.

Der Prozeßrechner 5 führt einen vorgegebenen Steuerungsablauf zur Erzeugung einer Oxidationsschicht auf den Halbleiterscheiben 2 durch. Ein solcher Steuerungsablauf ist der schon geschilderte und in Fig. 1 dargestellte Steuerungsablauf eines Oxidationsprozesses. Mit einem solchen Steuerungsablauf soll die Soll-Zielgröße - nämlich die Oxidationsschichtdicke - erreicht werden. Der Prozeßrechner 5 berechnet anhand einer Modellrechnung die Ist-Zielgröße zu vorgewählten Zeitpunkten aus den gemessenen Parameterwerten. Die Parameter sind die Temperatur der Temperaturmeßfühler 6 und der Durchfluß der Gase, der von den Durchflußmessern 10 und 11 gemessen worden ist. Der Prozeßrechner 5 berechnet beispielsweise alle zwei Sekunden aus den gemessenen Parameterwerten die Ist-Zielgröße. Eine solche Modellrechnung kann z.B. mit Hilfe des Programmes "SUPREM III" (A PROGRAM for Integrated Circuit Process Modelling and Simulation von C. P. Ho, S. E. Hansen und P. M. Fahey, TECHNICAL REPORT No. SEL 84-001, Stanford Electronics Laboratories, Stanford University, Stanford, California, July 1984) durchgeführt werden. Der Prozeßrechner 5 vergleicht nach Berechnung der Ist-Zielgröße die Soll-Zielgröße mit der Ist-Zielgröße und beendet den Oxidationsprozeß, wenn die Ist-Zielgröße der Soll-Zielgröße entspricht. Dadurch wird auch bei einer Störung (z.B. Temperaturschwankung) des Steuerungsablaufes die Soll-Zielgröße erreicht.

Anhand der Fig. 1 wird im folgendenden der Steuerungsablauf näher erläuert. Nachdem die vorgegebene Zielgröße, die Schichtdicke der Oxidationsschicht, und weitere Prozeßparameterwerte über die Eingabeanordnung 16 eingegeben worden sind, wird bis zum Zeitpunkt to der mit Halbleiterscheiben 2 bestückte Ofen 1 auf 800°C aufgeheizt. Zum Zeitpunkt to wird der Gaszufluß des Stickstoffs (N₂) von 1 l/min auf 5 l/min erhöht und zusätzlich Sauerstoff (O₂) mit 0,1 l/min zugeführt. Die Zeit zwischen to und t1 beträgt 10 Minuten. Vom Zeitpunkt t1 ab wird die Temperatur innerhalb von 30 Minuten bis zum Zeitpunkt t2 auf 950°C erhöht. Die Gaszufuhr des Stickstoffs wird vom Zeitpunkt t2 ab beendet und die des Sauerstoffs auf 3 l/min erhöht. Zum Zeitpunkt t3 soll die Soll-Zielgröße, d.h. die gewünschte Schichtdicke der Isolierschicht (Oxidationsschicht), erreicht sein. Die Zeit zwischen t2 und t3 hängt also davon ab, wenn die erforderliche Soll-Zielgröße erreicht ist. Vom Zeitpunkt to ab wird beispielsweise alle zwei Sekunden die Ist-Zielgröße, d.h. die Ist-Oxidationsschicht, mittels der Modellrechnung im Prozeßrechner 5 berechnet. Nach jeder Berechnung findet ein Vergleich zwischen der Soll-Zielgröße und der Ist-Zielgröße statt. Stellt der Prozeßrechner 5 fest, daß die Ist-Zielgröße die der Soll-Zielgröße erreicht hat, ist der Zietpunkt t3 erreicht und der Zufluß des Sauerstoffs wird beendet. Die Zeit zwischen t2 und t3 beträgt bei einem normalen Steuerungsablauf ca. 35 Minuten. Die Temperatur wird dann kontinuierlich auf 800°C erniedrigt. Die Zufuhr des Stickstoffs wird auf 5 l/min eingestellt. Nach Beendigung der vom Zeitpunkt t3 ab beginnenden Abkühlphase können die beschichteten Halbleiterscheiben 2 aus dem Ofen 1 genommen werden.

Während des Oxidationsprozesses wird jeder Meßwert vom Prozeßrechner 5 gespeichert und kann gegebenenfalls über die Ausgabeanordnung 17 ausgegeben werden.

Falls eine Störung des Prozesses auftritt, die das Erreichen der Soll-Zielgröße unmöglich macht, wird der Prozeß abgebrochen. Der Prozeßrechner hat für die Parameterwerte einen Bereich vorgegeben, der, falls er unter- bzw. überschritten wird, einen Abbruch des Prozesses zur Folge hat. Der vorgegebene Bereich ist so gewählt, daß eine einwandfreie Bearbeitung der Halbleiterscheiben möglich ist. Fällt beispielsweise eine Heizung 3 aus, wird vom Prozeßrechner 5 festgestellt, daß der vorgegebene Bereich unterschritten wird und dieser beendet den Prozeß. Da alle Meßwerte während des Prozesses gespeichert worden sind, ist eine Nachbearbeitung der Halbleiterscheiben nach der Reparatur der Heizung 3 auf einfache Weise möglich.

Da z.B. zur Herstellung einer integrierten Schaltung mehrere physikalisch/chemische Behandlungen in Öfen erforderlich sind, ergibt sich mit der Speicherung der Meßwerte während des Prozesses die Möglichkeit, Korrekturen über den gesamten Herstellungsprozeß durchzuführen.

Der Prozeß kann auch durch Regelung eines Parameters, z.B. des Durchflusses des Sauerstoffs, geregelt werden. Die anderen Parameter außer dem Durchfluß des Sauerstoffs sind, wie oben geschildert, vorgegegeben und nur der Durchfluß des Sauerstoffs wird durch den Vergleich der Soll-Zielgröße mit der berechneten Ist-Zielgröße geregelt.

## Patentansprüche

1. Verfahren zur Prozeßführung bei der physikalisch/chemischen Behandlung von Halbleitern in einem Ofen (1) mit einem Prozeßrechner (5), der, zur Erzeugung einer schicht mit bestimmter Zielgröße von bestimmten chemischen und/oder physikalischen Eigenschaften, die Parameter der dem Ofen zuführbaren Größen regelt, wobei der Prozeßrechner einen Vergleich vorgegebener Parameterwerte mit den gemessenen Parameterwerten durchführt,
dadurch gekennzeichnet, daß der Prozeßrechner (5) zu vorgewählten Zeitpunkten aus den gemessenen Parameterwerten mittels einer Modellrechnung den Ist-Wert der Zielgröße berechnet und die Behandlung beendet, wenn der Ist-Wert den Soll-Wert der Zielgröße erreicht.

2. Verfahren nach Anspruch 1,
dadurch gekennzeichnet, daß der Prozeßrechner (5) die Behandlung abbricht, wenn ein Parameterwert einen vorgegebenen Bereich unter- bzw. überschreitet.

3. Verfahren nach Anspruch 1 oder 2,
dadurch gekennzeichnet, daß die Behandlung der Halbleiter (2) aus einer Schichtbildung in einem Ofen (1) unter Zuhilfenahme eines Trägergases und wenigstens eines weiteren Gases besteht und der Prozeßrechner (5) den Durchfluß der Gase und die Temperatur des Ofens regelt.

## Claims

1. A method for process control during the physical/chemical treatment of semiconductors in a furnace (1) with a process computer (5), which controls the parameters of the variables to be applied to the furnace in order to form a layer with a given target variable of given chemical and/or physical properties, the process computer carrying out a comparison of predetermined parameter values with the measured parameter values, characterized in that the process computer (5) determines the actual value of the target variable value at preselected instants from the measured parameter values by means of a model calculation and terminates the treatment when the actual value equals the nominal value of the target variable.

2. A method as claimed in Claim 1, characterized in that the process computer (5) interrupts the treatment when a parameter value drops below or exceeds a given range.

3. A method as claimed in Claim 1 or 2, characterized in that the treatment of the semiconductors (2) consists in forming a layer in a furnace (1) with the aid of a carrier gas and of at least one further gas and the process computer (5) controls the flow rate of the gases and the temperature of the furnace.

## Revendications

1. Méthode de conduite du processus dans le traitement physico-chimique de semi-conducteurs dans un four (1), au moyen d'un calculateur de processus (5) qui, pour produire une couche ayant une grandeur visée déterminée pour certaines propriétés chimiques et/ou physiques, assure la régulation des paramètres des grandeurs pouvant être amenées au four, le calculateur de processus procédant à une comparaison entre des valeurs prescrites des paramètres et leurs valeurs mesurées, caractérisée en ce que le calculateur de processus (5), à des instants fixés à l'avance, calcule au moyen d'un calcul type, à partir des valeurs mesurées des paramètres, la valeur réelle de la grandeur visée et met fin au traitement quand la valeur réelle atteint la valeur de consigne de la valeur visée.

2. Méthode suivant la revendication 1, caractérisée en ce que le calculateur de processus (5) interrompt le traitement si la valeur d'un paramètre quitte une plage prescrite en lui devenant supérieure ou inférieure.

3. Méthode suivant la revendication 1 ou 2, caractérisée en ce que le traitement des semi-conducteurs (2) consiste en la formation d'une couche dans un four (1) à l'aide d'un gaz porteur et d'au moins un autre gaz, et que le calculateur de processus (5) régit le débit des gaz et la température du four.
